(19) Europäisches Patentamt
European Patent Office
Office européen des brevets

(11) EP 2 490 228 B1

(12) **EUROPEAN PATENT SPECIFICATION**

(45) Date of publication and mention of the grant of the patent:
**23.03.2016 Bulletin 2016/12**

(21) Application number: **10823604.3**

(22) Date of filing: **13.10.2010**

(51) Int Cl.:
*H01B 1/22* (2006.01)      *H01L 31/042* (2006.01)
*C08F 2/44* (2006.01)       *H01B 1/16* (2006.01)
*H01L 31/0224* (2006.01)

(86) International application number:
**PCT/KR2010/007001**

(87) International publication number:
**WO 2011/046365 (21.04.2011 Gazette 2011/16)**

(54) **SILVER PASTE COMPOSITION AND SOLAR CELL USING SAME**

SILBERPASTENZUSAMMENSETZUNG UND SOLARZELLE DAMIT

COMPOSITION DE PÂTE À L'ARGENT ET PILE SOLAIRE L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.10.2009 KR 20090097296**
**13.10.2010 KR 20100099638**

(43) Date of publication of application:
**22.08.2012 Bulletin 2012/34**

(73) Proprietor: **LG Chem, Ltd.**
**Youngdungpo-gu**
**Seoul 150-721 (KR)**

(72) Inventors:
• **KIM, Min-Seo**
**Daejeon 302-120 (KR)**

• **HEO, Soo-Yeon**
**Daejeon 305-761 (KR)**

(74) Representative: **Goddar, Heinz J.**
**Boehmert & Boehmert**
**Anwaltspartnerschaft mbB**
**Patentanwälte Rechtsanwälte**
**Pettenkoferstrasse 20-22**
**80336 München (DE)**

(56) References cited:
EP-A1- 2 330 084        WO-A1-2008/078374
JP-A- 11 193 613        JP-A- 2009 194 121
KR-A- 20090 078 252     KR-A- 20090 089 617
KR-B1- 100 825 880      US-A1- 2009 107 546

**Description**

BACKGROUND OF THE INVENTION

Field of the Invention

The present invention relates to a silver paste composition and a solar cell using the same, and more particularly, to a silver paste composition for forming a front electrode of a solar cell which may improve uniformity, stability, and adhesive strength of printed patterns when the silver paste composition is applied through screen printing, and the like, and a silicon solar cell using the same.

Description of the Related Art

Recently, it is expected that conventional energy sources such as oil or charcoal will be exhausted, and thus, interests in alternative energy are increasing. Among alternative energy, particularly a solar cell has abundant energy sources and does not cause environmental pollution, and thus, it becomes the object of attention.

The solar cell is classified into a solar heat cell that produces vapor required to run a turbine using solar heat, and a solar light cell that converts photons into electrical energy using properties of a semiconductor. Generally, the solar light cell (hereinafter referred to as a solar cell) is represented as a solar cell.

The solar cell largely includes a silicon solar cell, a compound semiconductor solar cell, and a tandem solar cell according to raw material. Among them, the silicon solar cell leads the solar cell market.

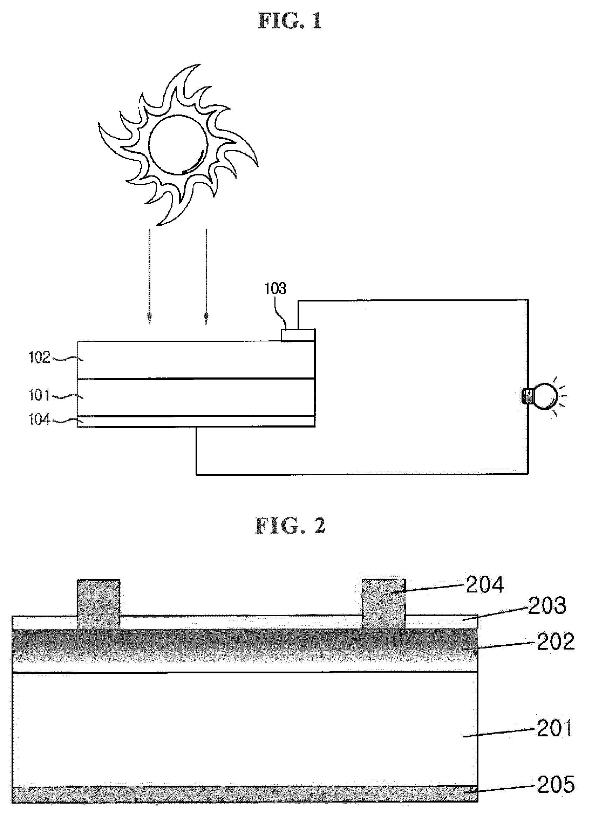

FIG. 1 is a cross-sectional view illustrating a basic structure of a silicon solar cell. Referring to FIG. 1, the silicon solar cell includes a substrate 101 of a p-type silicon semiconductor, and an emitter layer 102 of an n-type silicon semiconductor. A p-n junction is formed at an interface between the substrate 101 and the emitter layer 102 in a similar way to a diode.

When light falls on a solar cell having the above-mentioned structure, electrons and electron holes create in a silicon semiconductor doped with an impurity by the photovoltaic effect. Specifically, electrons create in the emitter layer 102 of an n-type silicon semiconductor as majority carriers, and electron holes create in the substrate 101 of a p-type silicon semiconductor as majority carriers. The electrons and electron holes created by the photovoltaic effect are drawn toward the n-type silicon semiconductor and the p-type silicon semiconductor, and move to a front electrode 103 on the emitter layer 102 and a rear electrode 104 below the substrate 101, respectively. When the front electrode 103 and the rear electrode 104 are connected to each other, electrical current flows.

Conventionally, a silver paste composition is used to form the front electrode 103, and an aluminum paste composition is used to form the rear electrode 104. In particular, the front electrode 103 needs a small pattern width and a large pattern height for a maximum amount of incident light and good electrical connection, and accordingly, a silver paste composition of high viscosity is prepared.

However, when a high viscosity composition is printed, the high viscosity composition does not ensure uniformity of printed patterns, and leaves much residues, which result in shadowing of a front surface of a solar cell.

Accordingly, there is a need to develop a paste composition that ensures uniformity of printed patterns and reduces occurrence of residues, although the paste composition has high viscosity.

SUMMARY OF THE INVENTION

Therefore, it is an object of the present invention to provide a silver paste composition for forming a front electrode of a solar cell that may ensure uniformity of printed patterns, reduced occurrence of residues and good preservation, as well as high viscosity, and a silicon solar cell using the same.

To achieve the object, a silver paste composition including the features of claim 1 is used.

The silver paste composition including the plasticizer according to the present invention has improved processability and flexibility, and thus, enables improvement in rolling properties, leveling properties and wettability of the paste composition when the silver paste composition is used in forming printed patterns, so that adhesion between a substrate and the printed patterns is improved.

The plasticizer of the present invention includes benzoic acid ester.

The content of the platicizer according to the present invention is 0.01 to 15 parts by weight per 100 parts by weight of the silver paste composition.

To form a front electrode of a solar cell and to manufacture a solar cell, the silver paste composition of the present invention may be applied on an anti-reflection film.

EFFECTS OF THE INVENTION

According to the present invention, a silver paste composition for forming a front electrode has improved rolling and leveling properties, and accordingly, the silver paste composition enables uniform generation of fine patterns and reduced occurrence of residues.

Also, the silver paste composition for forming a front electrode reduces a difference in thermal expansion between a substrate and printed patterns, and particularly, reduces curling of the edges, and accordingly, the silver paste composition improves stability and uniformity of printed patterns.

BRIEF DESCRIPTION OF THE DRAWINGS

Other objects and aspects of the present invention will become apparent from the following description of embodiments with reference to the accompanying drawing in which:

FIG. 1 is a schematic cross-sectional view illustrating a structure of a conventional silicon solar cell.

FIG. 2 is a schematic cross-sectional view illustrating a silicon solar cell according to an embodiment of the present invention.

FIG. 3 is an optical microscopy image illustrating a printed pattern formed using a composition of example 2 according to the present invention.

FIG. 4 is an optical microscopy image illustrating a printed pattern formed using a composition of comparative example 1 according to the present invention.

FIG. 5 is an optical microscopy image illustrating cross sections of printed patterns formed using compositions of comparative example 1 and example 2 according to the present invention.

DESCRIPTION OF THE PREFERRED EMBODIMENT

Hereinafter, preferred embodiments of the present invention will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best explanation.

As described above, a silver paste composition of the present invention includes silver powder, glass frit powder, an organic binder, and a plasticizer, wherein the plasticizer is benzoic acid.

In the silver paste composition of the present invention, the content of the platicizer is 0.01 to 15 parts by weight per 100 parts by weight of the silver paste composition, preferably 0.1 to 10 parts by weight, more preferably 1 to 5 parts by weight.

When the content of the platicizer is less than 0.01 parts by weight, the silver paste composition hardly has leveling properties and shows low wettability with a substrate. When the content of the platicizer exceeds 15 parts by weight, a silver paste has a reduction in rolling properties due to a large pattern width and a reduced content of a main binder when being printed, resulting in poor printability.

With regard to the silver powder included in the present invention, silver particles may include, but are not limited to, any silver particles used conventionally in the art. For example, silver particles may include, but are not limited to, any silver particles having an average particle size between 0.5 to 7 $\mu$m.

The glass frit powder usable in the silver paste composition of the present invention may include, but are not limited to, any glass frit powder used conventionally in the art. For example, the glass frit powder may include, but are not limited to, lead oxide and/or bismuth oxide. Specifically, the glass frit powder may include, but are not limited to, $SiO_2$-PbO based powder, $SiO_2$-PbO-$B_2O_3$ based powder, $Bi_2O_3$-$B_2O_3$-$SiO_2$ based powder, PbO-$Bi_2O_3$-$B_2O_3$-$SiO_2$ based powder, or mixtures thereof.

The organic binder may be used to prepare the silver powder, the glass frit powder and the plasticizer in a paste phase. The organic binder used in the present invention may include, but are not limited to, any organic binder used to prepare a silver paste composition in the art. For example, the organic binder may include, but are not limited to, cellulose, butyl carbitol, terpineol, or mixtures thereof.

In the silver paste composition of the present invention, the glass frit powder and the organic binder may be selected depending on a specific usage of the silver paste composition. The content of the glass frit powder is 1 to 20 parts by weight per 100 parts of weight of the silver paste composition. The content of the organic binder is 5 to 30 parts by weight per 100 parts of weight of the silver paste composition. These content ranges enable easy electrode formation, and ensure viscosity suitable for screen printing and a proper aspect ratio to prevent a paste from flowing after screen printing.

The silver paste composition of the present invention is prepared by mixing the above components by various methods known in the art so that the components are uniformly dispersed.

Optionally, the silver paste composition of the present invention may further include an additional agent without departing from the spirit and scope of the invention. For example, the silver paste composition may further include a wetting agent, a thixotropic agent, and the like, according to necessity.

A method for preparing the silver paste composition of the present invention is described below. The silver paste composition is prepared by mixing the silver powder, the glass frit powder, and the binder (first mixing), and then adding plasticizer to the mixture, and mixing the plasticizer with the mixture (second mixing). In this instance, the components may be uniformly mixed using a 3-roll mill, and the like.

The simultaneous mixing of all components may allow the intended effects of the present invention, however when the plasticizer is mixed with other components at the same time, the plasticizer may be absorbed into the silver powder and the glass frit powder, and may not be uniformly dispersed in the paste. Accordingly, after the silver powder and the glass frit powder is sufficiently wetted with the binder in first mixing, the plasticizer is added (second mixing) and uniformly dispersed in the paste, so that effects of the plasticizer are maximized.

Hereinafter, a silicon solar cell using the silver paste composition of the present invention is described below with reference to FIG. 2. The description proposed herein is just a preferable example for the purpose of illustrations only, not intended to limit the scope of the invention, so it should be understood that other equivalents and modifications could be made thereto without departing from the spirit and scope of the invention.

FIG. 2 is a schematic cross-sectional view illustrating a silicon solar cell according to an embodiment of the present invention.

Referring to FIG. 2, the silicon solar cell according to an embodiment of the present invention a silicon semiconductor substrate 201, an emitter layer 202 on the substrate 201, an anti-reflection film 203 on the emitter layer 202, a front electrode 204 connected to the upper surface of the emitter layer 202 through the anti-reflection film 203, and a rear electrode 205 connected to the rear surface of the substrate 201.

The substrate 201 may be doped with p-type impurities of group 3 elements in the periodic table, such as B, Ga, In, and the like, and the emitter layer 202 may be doped with n-type impurities of group 5 elements in the periodic table, such as P, As, Sb, and the like. When the substrate 201 and the emitter layer 202 are doped with impurities of opposite conductivity type, a p-n junction may be formed at an interface between the substrate 201 and the emitter layer 202. In this instance, a p-n junction may be formed between the substrate 201 doped with n-type impurities and the emitter layer 202 doped with p-type impurities.

The anti-reflection film 203 may passivate a defect (for example, a dangling bond) existing on the surface of or in the bulk of the emitter layer 202, and may reduce reflectivity of solar rays incident on the front surface of the substrate 201. When the defect existing on/in the emitter layer 202 is passivated, a site where minority carriers are recombined may be removed, thereby increasing the open-circuit voltage of the solar cell. Also, a reduction in reflectivity of solar rays may increase an amount of light reaching the p-n junction, thereby increasing the short circuit current of the solar cell. Accordingly, increase in open-circuit voltage and short circuit current of the solar cell by the anti-reflection film 203 may contribute to improvement in conversion efficiency of the solar cell.

For example, the anti-reflection film 203 may have a single film structure of any one selected from the group consisting of a silicon nitride film, a silicon nitride film containing hydrogen, a silicon oxide film, a silicon oxynitride film, $MgF_2$, ZnS, $MgF_2$, $TiO_2$ and $CeO_2$ or a multiple film structure of at least two material films, however the present invention is not limited in this regard. Also, the anti-reflection film 203 may be formed by vacuum deposition, chemical vapor deposition, spin coating, screen printing, or spray coating, however a method for forming the anti-reflection film 203 according to the present invention is not limited in this regard.

The front electrode 204 and the rear electrode 205 may be electrodes made from silver and aluminum, respectively. The front electrode 204 may be made from the silver paste composition of the present invention. A silver electrode may have good electrical conductivity, and an aluminum electrode may have good electrical conductivity and high affinity for the silicon semiconductor substrate 201 to enable good connection therebetween.

The front electrode 204 and the rear electrode 205 may be formed by well-known various techniques, however screen printing is preferred. That is, the front electrode 205 is formed by screen-printing the silver paste composition of the present invention at a location where a front electrode is to be formed, followed by thermal treatment. During the thermal treatment, the front electrode 204 may penetrate the anti-reflection film 203 due to a punch-through phenomenon, and may be connected to the emitter layer 202.

Similarly, the rear electrode 205 is formed by printing an aluminum paste composition for forming a rear electrode, containing aluminum, quartz silica, a binder, and the like, on the rear surface of the substrate 201, followed by thermal treatment. During the thermal treatment of the rear electrode, aluminum, that is, one of the components in the rear electrode composition may diffuse through the rear surface of the substrate 201, so that a back surface field (not shown) layer may be formed at an interface between the rear electrode 205 and the substrate 201. The back surface field layer may prevent carriers from moving to the rear surface of the substrate 201 and recombinating. Prevention of carrier recombinatinon may result in increased open-circuit voltage and increased fill factor, thereby improving conversion efficiency of the solar cell.

Hereinafter, the present invention will be described in detail through specific examples.

Examples 1 to 4 and comparative examples 1 to 4

Each silver paste composition was prepared by mixing silver powder, glass frit powder, an organic binder (ethyl cellulose) and an additive (a plasticizer, a wetting agent and a thixotropic agent) according to composition (unit: weight%) shown in the following Table 1, followed by uniform dispersion using a 3-roll mill.

In Table 1, a plasticizer of examples 1 to 4 was dipropyleneglycol dibenzoate (DPD), a plasticizer of comparative example 1 was dioctyl phthalate (DOP), a plasticizer of comparative example 2 was dioctyl adipic acid (DOA), and a plasticizer of comparative example 3 was tricresyl phosphate (TCP).

Table 1

| | Silver | Glass frit | Content of additive | | | Binder |
| --- | --- | --- | --- | --- | --- | --- |
| | | | Plasticizer | Wetting agent | Thixotropic agent | Ethylcellulose |
| Example 1 | 80 | 4 | 1(DPD) | 0 | 0 | 15 |
| Example 2 | 80 | 4 | 2(DPD) | 0 | 0 | 14 |
| Example 3 | 80 | 4 | 3(DPD) | 0 | 0 | 13 |
| Example 4 | 80 | 4 | 4(DPD) | 0 | 0 | 12 |
| Comparative example 1 | 80 | 4 | 2(DOP) | 0.5 | 0.5 | 13 |
| Comparative example 2 | 80 | 4 | 2(DOA) | 0.5 | 0.5 | 13 |
| Comparative example 3 | 80 | 4 | 2(TCP) | 0.5 | 0.5 | 13 |
| Comparative example 4 | 80 | 4 | 0 | 0.5 | 0.5 | 15 |

**Test example 1: measurement of viscosity**

After the silver paste compositions according to examples 1 to 4 and comparative examples 1 to 4 were prepared as described above, a viscosity variation was measured. The viscosity variation was measured with a change in number of milling, and was measured over time.

(1) The viscosity variation ($V_m$) with a change in number of milling was computed from the following Mathematical formula 1, and viscosity was measured within about 200 seconds after a sample was prepared.

Mathematical formula 1

$$V_m = \frac{V_{m,12} - V_{m,4}}{V_{m,4}}$$

where $V_{m,4}$ is viscosity measured after milling is performed four times, and $V_{m,12}$ is viscosity measured after milling is performed twelve times.

In Table 2, $V_m$ of 10% or less is represented as O, $V_m$ greater than 10% and not greater than 30% is represented as $\Delta$, and $V_m$ greater than 30% is represented as X.

(2) The viscosity variation ($V_t$) over time was computed from the following Mathematical formula 2, and viscosity was measured within about 200 seconds after a sample was prepared at 50°C.

Mathematical formula 2

$$V_t = \frac{V_{t,72} - V_{t,0}}{V_{t,0}}$$

where $V_{t,0}$ is viscosity measured immediately after a sample is prepared, and $V_{t,72}$ is viscosity measured after a sample is prepared and preserved at 50°C for 72 hours.

In Table 2, $V_t$ of 10% or less is represented as O, $V_t$ greater than 10% and not greater than 30% is represented as $\Delta$, and $V_t$ greater than 30% is represented as X.

Table 2

| | Evaluation of viscosity variation | |
| --- | --- | --- |
| | Number of milling | Over time |
| Example 1 | O | O |
| Example 2 | O | O |
| Example 3 | O | O |
| Example 4 | O | O |
| Comparative Example 1 | $\Delta$ | $\Delta$ |
| Comparative Example 2 | $\Delta$ | $\Delta$ |
| Comparative Example 3 | $\Delta$ | $\Delta$ |
| Comparative example 4 | X | X |

As shown in Table 2, the test results show that the comparative example 4 has a large viscosity variation with a change of number of milling, while the examples have almost uniform viscosity regardless of number of milling.
Also, the test results teach that viscosity of the comparative example 4 significantly increases (at least 1.5 times) over time, while viscosity of the examples maintains within an increment of 10% or less.
Accordingly, it is found that the compositions of examples have smaller viscosity variation than the comparative example 4 without a plasticizer, and consequently, the silver paste composition of the present invention has higher stability. Also, it is found that addition of a plasticizer alone improves stability when a paste is preserved, without using any additive.

**Test example 2: measurement of pattern width**

The compositions prepared according to examples 1 to 4 and comparative examples 1 to 4 were printed in patterns having a pattern width of 120 $\mu$m by screen printing, and were dried at 200°C. The pattern width of the resulting printed patterns was measured.
A ratio of a minimum pattern width to a maximum pattern width was computed each pattern using the measured values. In Table 3 a ratio of 0.95 or more is represented as O, a ratio between 0.93 and 0.95, but not 0.95, is represented as $\Delta$, and a ratio less than 0.93 is represented as X.

Table 3

| | Pattern width variation |
| --- | --- |
| Example 1 | O |
| Example 2 | O |
| Example 3 | O |

(continued)

|  | Pattern width variation |
|---|---|
| Example 4 | O |
| Comparative example 1 | Δ |
| Comparative example 2 | Δ |
| Comparative example 3 | Δ |
| Comparative example 4 | X |

Referring to Table 3, it is found that the printed patterns formed from the compositions of the examples have a smaller variation in pattern width than that of comparative examples.

## Test example 3: observation of printed pattern

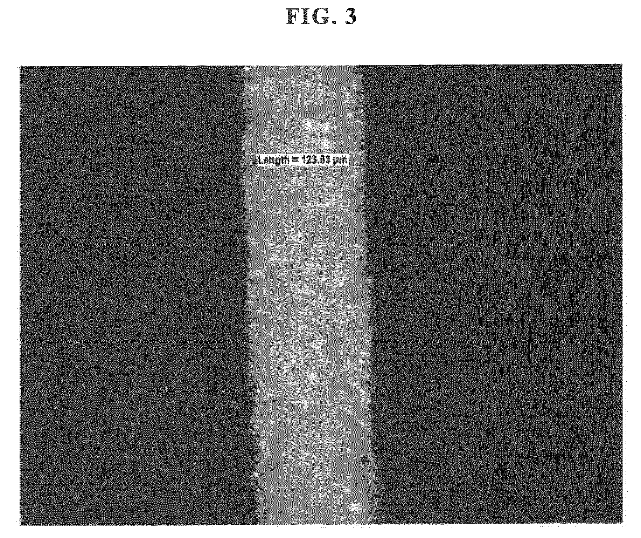

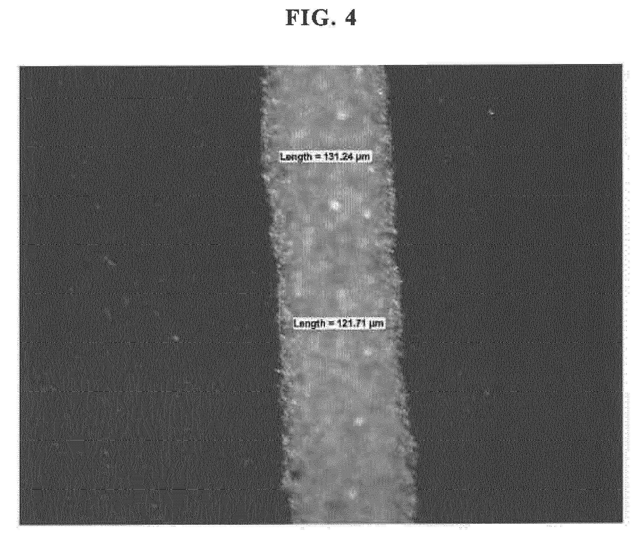

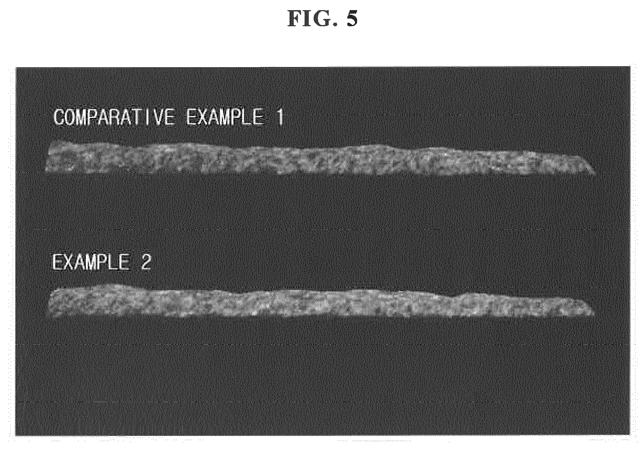

Among the above printed patterns, a pattern width of the printed patterns formed from the compositions of the example 2 and the comparative example 4 was observed using an optical microscope. The results are shown in FIG. 3 (example 2) and FIG. 4 (comparative example 4), and the cross sections of the printed patterns are shown in FIG. 5.

Referring to FIGS. 3 and 4, it is found that the printed pattern formed from the composition of the example 2 has smaller pattern width, uniform pattern and reduced occurrence of residue, compared with the comparative example 4.

Referring to FIG. 5, it is found that a pattern height of the printed pattern formed from the composition of the example 2 with a plasticizer only is about the same as that the comparative example 4 with a thixotropic agent (TA).

## Claims

1.   A silver paste composition for forming a front electrode of a solar cell, comprising:

   silver powder, glass frit powder, an organic binder, and a plasticizer, wherein the plasticizer is benzoic acid ester, and the content of the glass frit powder is 1 to 20 parts by weight, the content of the organic binder is 5 to 30 parts by weight, and the content of the plasticizer is 0.01 to 15 parts by weight, per 100 parts by weight of the silver paste composition.

2.   The silver paste composition for forming a front electrode of a solar cell according to claim 1, wherein the glass frit powder includes lead oxide or bismuth oxide.

3.   The silver paste composition for forming a front electrode of a solar cell according to claim 1, wherein the organic binder is any one selected from the group consisting of cellulose, butyl carbitol, and terpineol, or mixtures thereof.

4.   A method for preparing a silver paste composition for forming a front electrode of a solar cell, the method comprising:

   mixing silver powder, glass frit powder, and an organic binder; and
   adding a plasticizer to the mixture, and mixing the plasticizer with the mixture, wherein the plasticizer is benzoic acid, and the content of the glass frit powder is 1 to 20 parts by weight, the content of the organic binder is 5 to 30 parts by weight, and the content of the plasticizer is 0.01 to 15 parts by weight, per 100 parts by weight of the silver paste composition.

5.   A silicon solar cell, comprising:

   a silicon semiconductor substrate;
   an emitter layer on the substrate;
   an anti-reflection film on the emitter layer;
   a front electrode connected to the emitter layer through the anti-reflection film; and
   a rear electrode connected to the rear surface of the substrate,
   wherein the front electrode is formed by applying the silver paste composition defined in any one of claims 1 to 3 on the anti-reflection film in a predetermined pattern, and firing the silver paste composition.

**Patentansprüche**

1. Silberpastenzusammensetzung zum Bilden einer Vorderseitenelektrode einer Solarzelle, welche umfasst:

   Silberpulver, Glasfrittenpulver, ein organisches Bindemittel und einen Weichmacher, wobei der Weichmacher Benzoesäureester ist und der Gehalt des Glasfrittenpulvers 1 bis 20 Gewichtsteile ist, der Gehalt des organischen Bindemittels 5 bis 30 Gewichtsteile ist und der Gehalt des Weichmachers 0,01 bis 15 Gewichtsteile ist, pro 100 Gewichtsteilen der Silberpastenzusammensetzung.

2. Silberpastenzusammensetzung zum Bilden einer Vorderseitenelektrode einer Solarzelle nach Anspruch 1, wobei das Glasfrittenpulver Bleioxid oder Bismutoxid einschließt.

3. Silberpastenzusammensetzung zum Bilden einer Vorderseitenelektrode einer Solarzelle nach Anspruch 1, wobei das organische Bindemittel irgendeines ist, das ausgewählt ist aus der Gruppe bestehend aus Cellulose, Butylcarbitol und Terpineol oder Mischungen derselben.

4. Verfahren zum Herstellen einer Silberpastenzusammensetzung zum Bilden einer Vorderseitenelektrode einer Solarzelle, wobei das Verfahren umfasst:

   Mischen von Silberpulver, Glasfrittenpulver und eines organischen Bindemittels; und
   Zufügen eines Weichmachers zu der Mischung und Mischen des Weichmachers mit der Mischung, wobei der Weichmacher Benzoesäureester ist und der Gehalt des Glasfrittenpulvers 1 bis 20 Gewichtsteile ist, der Gehalt des organischen Bindemittels 5 bis 30 Gewichtsteile ist und der Gehalt des Weichmachers 0,01 bis 15 Gewichtsteile ist, pro 100 Gewichsteilen der Silberpastenzusammensetzung.

5. Siliziumsolarzelle, welche umfasst:

   ein Siliziumhalbleitersubstrat;
   eine Emitterschicht auf dem Substrat;
   einen Antireflektionsfilm auf der Emitterschicht;
   eine Vorderseitenelektrode, die mit der Emitterschicht über den Antireflektionsfilm verbunden ist; und
   eine Rückseitenelektrode, die mit der Rückseite des Substrats verbunden ist,
   wobei die Vorderseitenelektrode gebildet ist durch Auftragen der Silberpastenzusammensetzung, wie sie in einem der Ansprüche 1 bis 3 definiert ist, auf den Antireflektionsfilm in einem vorgegebenen Muster und Brennen der Silberpastenzusammensetzung.

**Revendications**

1. Une composition de pâte d'argent pour former une électrode avant d'une cellule solaire, comprenant :

   une poudre d'argent, une poudre de fritte de verre, un liant organique et un plastifiant, dans laquelle le plastifiant est un ester d'acide benzoïque, et la teneur en poudre de fritte de verre est comprise entre 1 et 20 parties en poids, la teneur en liant organique est comprise entre 5 et 30 en poids et la teneur en plastifiant est comprise entre 0,01 et 15 parties en poids pour 100 parties en poids de la composition de pâte d'argent.

2. La composition de pâte d'argent pour former une électrode avant d'une cellule solaire selon la revendication 1, dans laquelle la poudre de fritte de verre inclut de l'oxyde de plomb ou de l'oxyde de bismuth.

3. La composition de pâte d'argent pour former une électrode avant d'une cellule solaire selon la revendication 1, dans laquelle le liant organique est un liant sélectionné dans le groupe constitué par la cellulose, le butyle carbitol et le terpinéol, ou des mélanges de ceux-ci.

4. Un procédé pour préparer une composition de pâte d'argent pour former une électrode avant d'une cellule solaire, le procédé consistant à :

mélanger une poudre d'argent, une poudre de fritte de verre et un plastifiant ; et

ajouter un plastifiant au mélange, et à mélanger le plastifiant avec le mélange, dans lequel le plastifiant est de l'acide benzoïque, et la teneur en poudre de fritte de verre est comprise entre 1 et 20 parties en poids, la teneur en liant organique est comprise entre 5 et 30 parties en poids et la teneur en plastifiant est comprise entre 0,01 et 15 parties en poids pour 100 parties en poids de la composition de pâte d'argent.

5. Une cellule solaire en silicium, comprenant :

un substrat semi-conducteur en silicium ;

une couche émettrice formée sur le substrat ;

un film antireflet formé sur la couche émettrice ;

une électrode avant connectée à la couche émettrice par le film antireflet ; et

une électrode arrière connectée à une surface arrière du substrat,

dans laquelle l'électrode avant est formée par l'application de la composition de pâte d'argent définie selon l'une quelconque des revendications 1 à 3 sur le film antireflet en un motif prédéterminé et par le frittage de la composition de pâte d'argent.

## FIG. 1

## FIG. 2

FIG. 3

Length = 123.83 μm

## FIG. 4

Length = 131.24 μm

Length = 121.71 μm

## FIG. 5